# EUROPEAN PATENT SPECIFICATION

(11) **EP 2 299 489 B1**
(45) Date of publication and mention of the grant of the patent: **29.11.2017**
(21) Application number: 10176313.4
(22) Date of filing: 13.09.2010
(51) Int. Cl.: H01L 23/473, H01L 23/36, F28D 15/02

(54) **Cooled base plate for electric components**
Gekühlte Grundplatte für elektrische Bauteile
Plaque de base refroidie pour composants électriques

(30) Priority: 17.09.2009 FI 20095959
(43) Date of publication of application: 23.03.2011
(73) Proprietor: ABB Technology Oy, 00380 Helsinki (FI)
(72) Inventor: Väätäinen, Timo, 02610, Espoo (FI); Koivuluoma, Timo, 01710, Vantaa (FI)
(74) Representative: Kolster Oy Ab

(56) References cited:
- EP-A1- 2 031 332
- WO-A2-2009/037648
- JP-A- 3 055 874

## Description

### BACKGROUND OF THE INVENTION

The invention relates to a cooled base plate for electric components, the cooled base plate having a first side and a second, opposite side, the first side of which is provided for attaching exothermal electric components thereto and in the second, opposite side of which there is embedded a cooling channel system having a cooling fluid inlet at one end of the base plate and a cooling fluid outlet at a second end of the base plate, whereby the cooling channel system is embedded at a constant distance from the surface provided for the attachment of the electric components, that the cooling channel system consists of separate, finned pipes that are embedded in grooves provided in the base plate at a constant distance from the surface provided for the attachment of the electric components. This type of cooled base plate is disclosed in EP 2031332 A1. Other known cooled base plates are disclosed in eg. WO 2009/037648 A2 and JP 3055874 A.

Known simple base plate cooling structures are based on an inexpensive technology employed in car radiators, in which a cooling fluid, typically a cooling liquid, is fed at one end of a base plate into one inlet pipe, wherefrom the liquid is distributed into flow channels of the base plate and is discharged through one outlet pipe at the opposite end of the base plate into the cooling system.

A problem with a long flow channel is imbalance in temperature. This imbalance arises when cooling liquid becomes warm as it propagates in the flow channel, whereby a base plate of symmetrical dimensions is unable to transfer heat evenly to the warmer and warmer cooling liquid. This results in the fact that the cooling liquid gets gradually warmer and an exothermal electric component at the last position in the cooling circulation, i.e. a loss source, e.g. a semiconductor module or a resistor, runs inevitably hottest.

### SUMMARY OF THE INVENTION

The object of the invention is to eliminate the above-mentioned problem. This is achieved with a base plate which is characterized in that the thickness of the base plate increases in the direction from the inlet of the cooling channel system towards the outlet of the cooling channel system, i.e. in the flow direction of the cooling fluid for at least a portion of the length of the base plate, whereby the base plate's heat transfer surface consisting of the grooves in the base plate and associated with the finned rib pipes increases in the flow direction of the cooling fluid and whereby the protrusion of the finned pipes from the base plate reduces respectively in the flow direction of the cooling fluid.

Thus, the invention is based on a base plate that is asymmetrical in thickness and that allows temperature equalization of electric loss sources.

An additional advantage of the invention is savings in material, which results both in reduced mass of the base plate and in cost savings. The base plate may be made thinner at the beginning of cooling circulation, when the cooling fluid is still cold, while the base plate has its maximum thickness at the end of the cooling circulation, where larger heat transfer mass or surface area will be needed for transferring heat to heated cooling liquid.

### LIST OF DRAWINGS

In the following the invention will be described in greater detail by means of a few preferred examples of implementation, with reference to the attached drawings, in which
Figure 1 is a side view of a base plate according to the invention,
Figure 2 is a cross-sectional view of the base plate of Figure 1 at point II - II,
Figure 3 is a cross-sectional view of the base plate of Figure 1 at point III - III,
Figure 4 is a cross-sectional view of the base plate of Figure 1 at point IV - IV,
Figures 5 and 6 are side views of other preferred embodiments of the base plate according to the invention.

### DETAILED DESCRIPTION OF THE INVENTION

With reference to the drawings, they show a cooled base plate 1 for electric components according to the invention, a first side A (upper side in the drawings) of which base plate is provided for attaching thereto exothermal electric components 2, such as semiconductor modules and resistors, and on a second, opposite side B (lower side in the drawings) of which there is embedded a cooling channel system 3 having a cooling fluid inlet 4 at one end of the base plate and a cooling fluid outlet 5 at a second end of the base plate.

It is essential in this structure that the thickness of the base plate 1 mainly increases in the direction from the inlet 4 of the cooling channel system 3 towards the outlet 5 of the cooling channel system 5, i.e. in the flow direction F of the cooling fluid for at least a portion of the length of the base plate 1. In other words, this may also be expressed such that the thickness of the base plate 1 is reduced at the beginning of the cooling fluid flow.

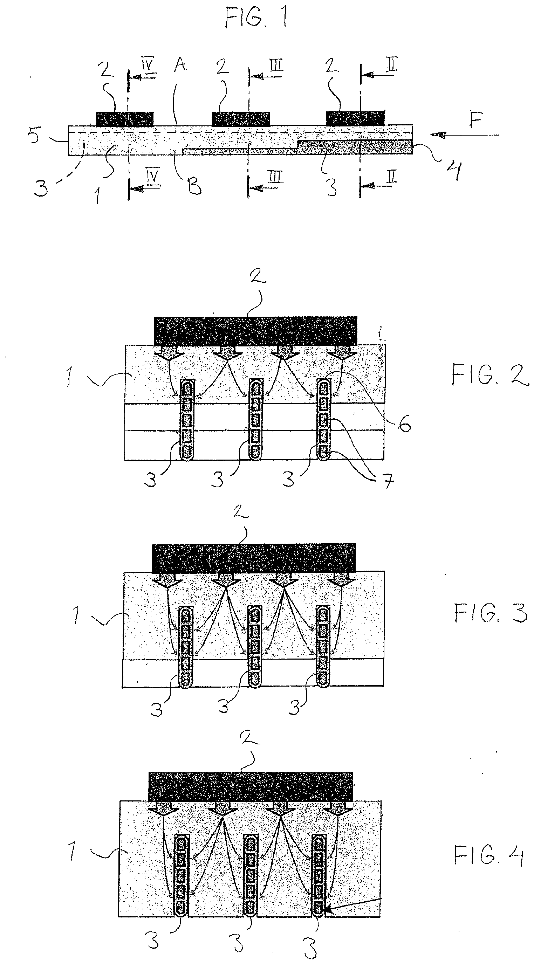

In the case of Figures 1 to 4 the thickness of the base plate 1 increases stepwise, preferably in the region of every exothermal electric component 2 or electric component array that is next in the flow direction F of the cooling fluid.

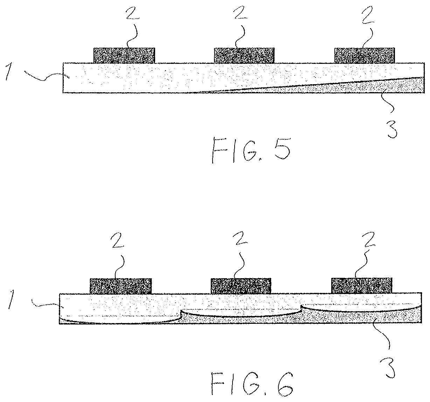

In the embodiment of Figure 5 the thickness of the base plate 1 increases at first continuously for a portion of the length of the base plate 1, the rest of the base plate 1 being uniform in thickness in the region of the last electric component 2 or electric component array.

In accordance with Figure 6, the thickness of the base plate 1 may increase as successive, protruding, for instance convex, wavy areas in the region of every exothermal electric component or electric component array that is next in the flow direction of the cooling fluid.

Areas of the base plate 1 that rise in the form of columns may also be possible, or these areas may be associated with the base plates 1 having the shape as described above. All these alternatives have not been described in the drawings, because the base plate shape that is asymmetrical and varying in thickness in accordance with the invention may be implemented in a variety of ways within the scope of the invention.

In the present implementations the cooling channel system 3 associated with the base plate 1 consists of separate, finned pipes that are embedded in grooves 6 machined in the base plate 1 at a substantially even distance from a surface A provided for the attachment of electric components, whereby the base plate's heat transfer surface consisting of the grooves in the base plate 1 and associated with the finned rib pipes 3 increases in the flow direction F of the cooling fluid and whereby the protrusion of the finned pipes 3 from the base plate 1 reduces respectively in the flow direction of the cooling fluid. Each finned pipe 3 comprises here advantageously several superimposed flow channels 7.

The electric component 2, which is on the side of the cooling fluid inlet 4 and receives liquid at its coldest and which is attached to the base plate 1 optimized in thickness in the above-described manner in accordance with the invention, encounters the smallest heat transfer area. This heat transfer area then appropriately increases as the cooling liquid gets warmer, when it propagates towards the outlet 5, and consequently the difference in temperature between the electric components 2 is minimized irrespective of their location on the base plate 1 in view of the cooling fluid flow.

In addition, the shape of the base plate may be optimized such that the internal temperature differences of the electric component 2 are to be minimized. This is necessary in the case of current semiconductors, when the length of a module may be even more than 300mm. Examples of this include semiconductor chips in series, in connection with which temperature differences must be minimized, so that asymmetrical current distribution resulting from the temperature difference is minimized. An optimized base plate 1 of this kind may be, for instance, similar to the one shown in Figure 6, whereby cooling area is largest at the centre of the electric component array 2.

The above specification is only intended to illustrate the basic idea of the invention. Thus, a person skilled in the art may modify its details within the scope of the attached claims. Thus, for instance, the cooling channel system may consist of any appropriate pipes and their cross-sectional shape is not restricted to the finned pipe structure, as the cross section of the pipe may be circular, for instance. It is also conceivable that the channel system is provided in the base plate itself.

## Claims

1. A cooled base plate (1) for electric components, the cooled base plate having a first side (A) and a second side (B), the first side (A) of which is provided for attaching exothermal electric components (2) thereto and in the second, opposite side (B) of which there is embedded a cooling channel system (3) having a cooling fluid inlet (4) at one end of the base plate (1) and a cooling fluid outlet (5) at a second end of the base plate (1), whereby the cooling channel system (3) is embedded at a constant distance from the surface (A) provided for the attachment of the electric components (2), that the cooling channel system (3) consists of separate, finned pipes that are embedded in grooves (6) provided in the base plate (1) at a constant distance from the surface (A) provided for the attachment of the electric components (2), **char-acterized** in that the thickness of the base plate (1) increases in the direction from the inlet (4) of the cooling channel system (3) towards the outlet (5) of the cooling channel system (3), i.e. in the flow direction (F) of the cooling fluid for at least a portion of the length of the base plate (1), whereby the base plate's heat transfer surface consisting of the grooves in the base plate (1) and associated with the finned rib pipes (3) increases in the flow direction (F) of the cooling fluid and whereby the protrusion of the finned pipes (3) from the base plate (1) reduces respectively in the flow direction of the cooling fluid.

2. The base plate of claim 1, **characterized in that** the thickness of the base plate (1) increases stepwise, in the region of every exothermal electric component (2) or electric component array that is next in the flow direction (F) of the cooling fluid.

3. The base plate of claim 1, **characterized in that** the thickness of the base plate (1) increases continuously.

4. The base plate of claim 1, **characterized in that** the thickness of the base plate (1) increases as successive, protruding convex, wavy or column-form areas in the region of every exothermal electric component (2) or electric component array that is next in the flow direction of the cooling fluid.

5. The base plate of claim 1, **characterized in that** each finned pipe (3) comprises a plurality of superimposed flow channels (7).

## Patentansprüche

1. Gekühlte Grundplatte (1) für elektrische Bauteile, wobei die gekühlte Grundplatte eine erste Seite (A) und eine zweite Seite (B) hat, wobei die erste Seite (A) davon vorgesehen ist, um exotherme elektrische Bauteile (2) daran zu befestigen und in der zweiten, gegenüberliegenden Seite (B) davon ein Kühlkanalsystem (3) eingebettet ist, das einen Kühlfluideinlass (4) an einem Ende der Grundplatte (1) und einen Kühlfluidauslass (5) an einem zweiten Ende der Grundplatte (1) hat, wobei das Kühlkanalsystem (3) in einem konstanten Abstand zu der Oberfläche (A), die für die Befestigung von exothermen elektrischen Bauteilen (2) vorgesehen ist, eingebettet ist, dass das Kühlkanalsystem (3) aus getrennten, gerippten Rohren besteht, die in Nuten (6) eingebettet sind, die in der Grundplatte (1) in einem konstanten Abstand zu der Oberfläche (A) vorgesehenen sind, die für die Befestigung von exothermen elektrischen Bauteilen (2) vorgesehen ist, **dadurch gekennzeichnet, dass** die Dicke der Grundplatte (1) in die Richtung von dem Einlass (4) des Kühlkanalsystems (3) hin zu dem Auslass (5) des Kühlkanalsystems (3) zunimmt, d.h. in der Strömungsrichtung (F) des Kühlfluids für mindestens einen Abschnitt der Länge der Grundplatte (1), wobei die Wärmeübertragungsoberfläche der Grundplatte, die aus den Nuten in der Grundplatte (1) besteht und zu den gerippten Rippenrohren (3) zugehörig ist, in der Strömungsrichtung (F) des Kühlfluids zunimmt, und wobei das Hervorstehen der gerippten Rohre (3) aus der Grundplatte (1) in der Strömungsrichtung des Kühlfluids entsprechend abnimmt.

2. Grundplatte nach Anspruch 1, **dadurch gekennzeichnet, dass** die Dicke der Grundplatte (1) in der Region jedes exothermen elektrischen Bauteils (2) oder Felds von elektrischen Bauteilen, das in der Strömungsrichtung (F) des Kühlfluids als nächstes kommt, schrittweise zunimmt.

3. Grundplatte nach Anspruch 1, **dadurch gekennzeichnet, dass** die Dicke der Grundplatte (1) kontinuierlich zunimmt.

4. Grundplatte nach Anspruch 1, **dadurch gekennzeichnet, dass** die Dicke der Grundplatte (1) in der Region jedes exothermen elektrischen Bauteils (2) oder Felds von elektrischen Bauteilen, das in der Strömungsrichtung des Kühlfluids als nächstes kommt, als sukzessive, hervorstehend convexe, wellige oder spaltenförmige Bereiche zunimmt.

5. Grundplatte nach Anspruch 1, **dadurch gekennzeichnet, dass** jedes gerippte Rohr (3) eine Mehrzahl von überlagernden Strömungskanälen (7) umfasst.

## Revendications

1. Plaque de base refroidie (1) pour des composants électriques, la plaque de base refroidie ayant un premier côté (A) et un deuxième côté (B), son premier côté (A) étant prévu pour y fixer des composants électriques exothermes (2) et dans le deuxième côté opposé (B) de laquelle est incorporé un système de canaux de refroidissement (3) ayant une admission de fluide de refroidissement (4) au niveau d'une extrémité de la plaque de base (1) et une évacuation de fluide de refroidissement (5) au niveau d'une deuxième extrémité de la plaque de base (1), moyennant quoi le système de canaux de refroidissement (3) est incorporé à une distance constante par rapport à la surface (A) prévue pour la fixation des composants électriques (2), le système de canaux de refroidissement (3) est constitué de tuyaux à ailettes séparés qui sont incorporés dans des rainures (6) prévues dans la plaque de base (1) à une distance constante par rapport à la surface (A) prévue pour la fixation des composants électriques (2), **caractérisée en ce que** l'épaisseur de la plaque de base (1) augmente dans la direction à partir de l'admission (4) du système de canaux de refroidissement (3) en direction de l'évacuation (5) du système de canaux de refroidissement (3), c'est-à-dire dans la direction d'écoulement (F) du fluide de refroidissement pour au moins une partie de la longueur de la plaque de base (1), moyennant quoi la surface de transfert de chaleur de la plaque de base constituée des rainures dans la plaque de base (1) et associée aux tuyaux nervurés à ailettes (3) augmente dans la direction d'écoulement (F) du fluide de refroidissement et moyennant quoi la saillie des tuyaux à ailettes (3) à partir de la plaque de base (1) se réduit respectivement dans la direction d'écoulement du fluide de refroidissement.

2. Plaque de base selon la revendication 1, **caractérisée en ce que** l'épaisseur de la plaque de base (1) augmente par étapes, dans la région de chaque composant électrique exotherme (2) ou groupe de composants électriques qui est le suivant dans la direction d'écoulement (F) du fluide de refroidissement (F).

3. Plaque de base selon la revendication 1, **caractérisée en ce que** l'épaisseur de la plaque de base (1) augmente de manière continue.

4. Plaque de base selon la revendication 1, **caractérisée en ce que** l'épaisseur de la plaque de base (1) augmente en tant que zones convexes, sinueuses ou en forme de colonne en saillie successives dans la région de chaque composant électrique exotherme (2) ou groupe de composants électriques qui est le suivant dans la direction d'écoulement du fluide de refroidissement.

5. Plaque de base selon la revendication 1, **caractérisée en ce que** chaque tuyau à ailettes (3) comprend une pluralité de canaux d'écoulement superposés (7).
